(19) Europäisches Patentamt
European Patent Office
Office européen des brevets

(11) **EP 4 449 609 B1**

(12) **FASCICULE DE BREVET EUROPEEN**

(45) Date de publication et mention de la délivrance du brevet:
**04.02.2026 Bulletin 2026/06**

(21) Numéro de dépôt: **22834648.2**

(22) Date de dépôt: **13.12.2022**

(51) Classification Internationale des Brevets (IPC):
***H03H 17/00*** *(2006.01)*

(52) Classification Coopérative des Brevets (CPC):
**H03H 17/0009**

(86) Numéro de dépôt international:
**PCT/EP2022/085654**

(87) Numéro de publication internationale:
**WO 2023/110891 (22.06.2023 Gazette 2023/25)**

(54) **PROCEDE DE GENERATION D'UN TEMPS DE PROPAGATION DE GROUPE NEGATIF, DISPOSITIF ELECTRONIQUE ET PRODUIT PROGRAMME D'ORDINATEUR ASSOCIE**

VERFAHREN ZUR ERZEUGUNG EINER NEGATIVEN GRUPPENVERZÖGERUNG UND ZUGEHÖRIGE ELEKTRONISCHE VORRICHTUNG UND COMPUTERPROGRAMMPRODUKT

METHOD FOR GENERATING A NEGATIVE GROUP DELAY, AND ASSOCIATED ELECTRONIC DEVICE AND COMPUTER PROGRAM PRODUCT

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorité: **17.12.2021 FR 2113789**

(43) Date de publication de la demande:
**23.10.2024 Bulletin 2024/43**

(73) Titulaires:
- **Université d'Aix-Marseille**
  **13007 Marseille (FR)**
- **Centre National de la Recherche Scientifique**
  **75016 Paris Cedex 16 (FR)**

(72) Inventeurs:
- **RAHAJANDRAIBE, Wenceslas**
  **13013 Marseille (FR)**
- **GUERIN, Mathieu**
  **13013 Marseille (FR)**

(74) Mandataire: **Cabinet Boettcher**
**5, rue de Vienne**
**75008 Paris (FR)**

(56) Documents cités:
**US-A1- 2020 389 726**

- **RAVELO BLAISE ET AL: "Low-Pass NGD Numerical Function and STM32 MCU Emulation Test", IEEE TRANSACTIONS ON INDUSTRIAL ELECTRONICS, IEEE SERVICE CENTER, PISCATAWAY, NJ, USA, vol. 69, no. 8, 10 September 2021 (2021-09-10), pages 8346 - 8355, XP011901824, ISSN: 0278-0046, [retrieved on 20220303], DOI: 10.1109/TIE.2021.3109543**
- **RAVELO BLAISE: "Elementary NGD IIR/FIR Systems", vol. 2, no. 2, 1 December 2014 (2014-12-01), pages 132 - 138, XP055948781, ISSN: 2315-4535, Retrieved from the Internet <URL:http://www.ijsps.com/uploadfile/2014/0806/20140806032305563.pdf> [retrieved on 20220803], DOI: 10.12720/ijsps.2.2.132-138**
- **HENNING U VOSS: "A universal negative group delay filter for the prediction of band-limited signals", ARXIV.ORG, CORNELL UNIVERSITY LIBRARY, 201 OLIN LIBRARY CORNELL UNIVERSITY ITHACA, NY 14853, 22 June 2017 (2017-06-22), XP081281831**

## Description

### Domaine technique

Le domaine de l'invention est celui de l'électronique, et plus particulièrement des dispositifs électroniques permettant de générer un temps de propagation de groupe négatif.

### Art antérieur

De manière générale, un circuit électronique est composé d'éléments de natures différentes (e.g. transistors, résistances, composants à inductance propre, condensateurs, etc.) connectés les uns aux autres selon différentes configurations (également appelées topologies), afin de générer une ou plusieurs fonctions précises (e.g. amplifier, filtrer, etc.). Parmi ces fonctions, il a été montré - comme introduit par exemple dans les documents « Low-Pass NGD Numerical Function and STM32 MCU Emulation Test » (RAVELO BLAISE ET AL, du 10/09/2021), "Elementary NGD IIR/FIR Systems" (RAVELO BLAISE, du 01/12/2014), ou "A universal negative group delay filter for the prediction of band-limited signais" (HENNING U VOSS du 22/06/2017) - que certains circuits électroniques analogiques ont la propriété singulière de générer un temps de propagation de groupe négatif.

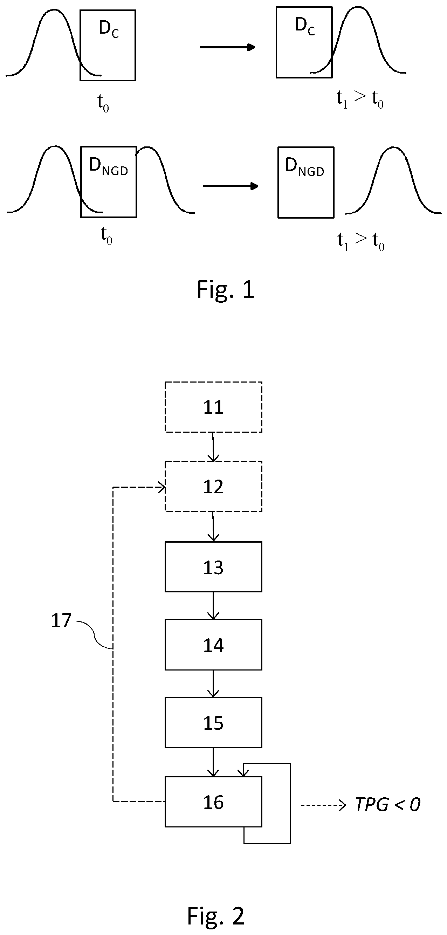

Une telle propriété est illustrée schématiquement en relation avec la **figure 1,** qui présente une comparaison des résultats de l'interaction d'un signal de forme gaussienne (i.e. en cloche) avec un dispositif classique $D_C$ d'une part, et de l'interaction de ce même signal avec un dispositif à temps de propagation de groupe négatif $D_{NGD}$ d'autre part. Sur cette figure, le dispositif classique $D_C$ et le dispositif à temps de propagation de groupe négatif $D_{NGD}$ sont représentés sous forme de boîte noire, et il est supposé, dans un modèle volontairement simplifié à des fins explicatives, que le signal ne subit pas de déformation de forme en traversant l'un ou l'autre des dispositifs.

On s'intéresse en premier lieu au dispositif classique $D_C$. Une première portion du signal, correspondant à un front montant, pénètre dans le dispositif classique $D_C$ à l'instant $t_0$. Comme montré sur la figure 1, le signal met un certain temps à ressortir du dispositif, et le temps de propagation de groupe (TPG) du dispositif correspond à l'intervalle de temps entre le moment où le maximum de l'amplitude du signal entre dans le dispositif et le moment où il en ressort. Physiquement, le temps de propagation de groupe est associé à la vitesse de propagation de l'énergie contenue dans ce signal, et il correspond généralement à un retard induit par le dispositif sur le signal.

Si on s'intéresse maintenant au dispositif à temps de propagation de groupe négatif $D_{NGD}$, on constate qu'au moment $t_0$ où le signal commence à pénétrer dans ce dispositif, il en est également déjà en grande partie ressorti. Plus particulièrement, l'amplitude maximale du signal de sortie sort du dispositif $D_{NGD}$ avant même que l'amplitude maximale du signal d'entrée n'y pénètre, d'où la désignation de « *temps de propagation de groupe négatif* » pour qualifier cette propriété singulière du dispositif $D_{NGD}$. En d'autres termes, le dispositif à temps de propagation de groupe négatif $D_{NGD}$ est en quelque sorte capable de régénérer le signal d'entrée en anticipant l'évolution de sa forme temporelle, i.e. de générer une avance plutôt qu'un retard.

Alors qu'on comprend aisément qu'une telle propriété présente un potentiel indéniable dans de nombreux domaines d'activité (e.g. physique, biologie, médecine, et plus généralement dans tout domaine où le temps de réaction d'un dispositif électronique revêt une importance) force est de constater que ses applications pratiques sont actuellement très limitées, voire quasiment inexistantes.

Ceci tient essentiellement à de nombreuses contraintes et limites associées aux solutions actuelles de génération d'un temps de propagation de groupe négatif.

En premier lieu, avec les dispositifs à temps de propagation de groupe négatif actuels, la génération du temps de propagation de groupe négatif est circonscrite à une plage de fréquences très limitée, ou à tout le moins relativement étroite. Le temps de propagation de groupe négatif n'est donc généralement pas obtenu sur toute la largeur de bande du signal à traiter, ni même sur une majeure partie de cette largeur de bande, ce qui limite de manière importante ses possibilités d'applications pratiques. Par ailleurs, ce phénomène s'accompagne généralement également d'une forte atténuation de l'amplitude du signal de sortie.

En deuxième lieu, la valeur de temps de propagation de groupe négatif (i.e. l'avance) qu'il est possible d'obtenir au moyen d'un dispositif à temps de propagation de groupe négatif actuel est intrinsèquement liée non seulement à la topologie particulière du dispositif - c'est-à-dire à la manière dont les composants qui le composent sont connectés - mais également aux valeurs particulières de ces composants. En d'autres termes, pour une configuration donnée (i.e. topologie et valeur des composants) de dispositif analogique à temps de propagation de groupe négatif, une seule valeur de temps de propagation de groupe négatif est obtenue, ce qui en fait une solution relativement rigide. En outre, les dispositifs à temps de propagation de groupe négatif actuels, réalisés à base de circuits analogiques, ne permettent pas de synthétiser une avance au-delà de la seconde, ce qui les rend inexploitables pour de nombreuses applications pratiques (notamment des applications industrielles reposant sur l'exploitation de signaux lents). Aussi, ces solutions actuelles de génération d'un temps de propagation de groupe négatif souffrent d'un manque important de flexibilité et d'adaptabilité.

En troisième lieu, la génération d'un temps de propagation de groupe négatif impose des contraintes importantes en termes de dimensionnement des composants nécessaires à l'obtention d'une telle fonction, qui rendent ces solutions difficilement compatibles avec les exigences des applications industrielles actuelles. Par ailleurs, il a été constaté que, pour une même configuration de dispositif à temps de propagation de groupe négatif, une faible variation de certains facteurs est susceptible d'avoir un impact potentiellement important sur la valeur de temps de propagation de groupe négatif obtenue. Par exemple, des petites variations au niveau des conditions de fabrication des composants électroniques analogiques utilisés, ou encore des dérives liées à la montée en température de ces composants lors de leur utilisation, peuvent conduire à l'obtention de valeurs sensiblement différentes de temps de propagation de groupe négatif, voire même compromettre l'obtention d'un temps de propagation de groupe négatif. Ce caractère aléatoire ou incertain du temps de propagation de groupe négatif obtenu avec les solutions actuelles fait que celles-ci ne sont généralement pas considérées comme étant suffisamment fiables ou robustes pour des applications industrielles.

Ainsi, malgré son potentiel, les freins et verrous technologiques précédemment décrits sont tels que cette propriété de génération d'un temps de propagation de groupe négatif offerte par certains dispositifs électroniques analogiques apparaît majoritairement dans la littérature comme une singularité physique, sans réelle possibilité d'applications pratiques.

Il existe donc un besoin pour une solution de génération d'un temps de propagation de groupe négatif qui permette de s'affranchir au moins en partie de ces nombreuses contraintes de l'art antérieur.

**Résumé de l'invention**

La présente technique permet de proposer une solution visant à remédier à certains inconvénients de l'art antérieur. La présente technique se rapporte en effet à un procédé de de génération, par un dispositif électronique, à partir d'un signal fourni en entrée dudit dispositif électronique, d'un signal de sortie présentant un temps de propagation de groupe négatif vis-à-vis dudit signal d'entrée. Selon la technique proposée, un tel procédé comprend les étapes suivantes, mises en œuvre par une unité de traitement numérique programmable dudit dispositif électronique :

- l'obtention d'une fréquence d'échantillonnage associée à un signal numérique représentatif dudit signal d'entrée ;
- l'obtention d'une valeur de temps de propagation de groupe, dite valeur de temps de propagation de groupe négatif cible ;
- la détermination d'un ensemble de coefficients d'une équation aux différences, en fonction de ladite fréquence d'échantillonnage et de ladite valeur de temps de propagation de groupe négatif cible ;
- le calcul, à l'acquisition d'une valeur courante dudit signal numérique, d'une valeur courante correspondante dudit signal de sortie, au moyen de ladite équation aux différences.

Dans un mode de réalisation particulier, ladite équation aux différences est déterminée en fonction d'un mode de fonctionnement sélectionné parmi un mode récursif et un mode non récursif, et en fonction d'un ordre associé audit mode de fonctionnement.

Dans un mode de réalisation particulier, ledit signal d'entrée est un signal analogique, et le procédé comprend une étape de conversion analogique vers numérique dudit signal d'entrée, ladite étape de conversion comprenant l'échantillonnage dudit signal d'entrée à ladite fréquence d'échantillonnage, délivrant ledit signal numérique représentatif dudit signal d'entrée.

Selon une caractéristique particulière de ce mode de réalisation, le procédé comprend, préalablement à ladite étape de conversion analogique vers numérique, une étape de conditionnement dudit signal analogique d'entrée.

Dans un mode de réalisation particulier, ladite fréquence d'échantillonnage du signal analogique d'entrée est contrôlée par ladite unité de traitement numérique programmable.

Dans un mode de réalisation particulier, ladite fréquence d'échantillonnage du signal analogique d'entrée est adaptée en fonction d'un temps de montée et/ou de descente courant dudit signal d'entrée.

Selon un autre aspect, la présente technique se rapporte également à un dispositif électronique de génération d'un signal de sortie présentant un temps de propagation de groupe négatif vis-à-vis d'un signal fourni en entrée dudit dispositif électronique, ledit dispositif électronique comprenant une unité de traitement numérique programmable qui comprend :

- des moyens d'obtention d'une fréquence d'échantillonnage associée à un signal numérique représentatif dudit signal d'entrée ;
- des moyens d'obtention d'une valeur de temps de propagation de groupe, dite valeur de temps de propagation de groupe négatif cible ;
- des moyens de détermination d'un ensemble de coefficients d'une équation aux différences, en fonction de ladite fréquence d'échantillonnage et de de ladite valeur de temps de propagation de groupe négatif cible ;

- des moyens de calcul, à l'acquisition d'une valeur courante dudit signal numérique, d'une valeur courante correspondante dudit signal de sortie, au moyen de ladite équation aux différences.

Les moyens dudit dispositif électronique peuvent être adaptés à la mise en œuvre de l'un quelconque des modes de réalisation du procédé de la présente demande.

Dans un mode de réalisation particulier, ledit dispositif électronique comprend un convertisseur analogique vers numérique comprenant des moyens d'échantillonnage dudit signal d'entrée à ladite fréquence d'échantillonnage, délivrant ledit signal numérique représentatif dudit signal d'entrée, lorsque ledit signal d'entrée est analogique.

Dans un mode de réalisation particulier, ladite unité de traitement numérique programmable appartient au groupe comprenant :

- un microcontrôleur ;
- une machine virtuelle exécutée sur un ordinateur ;
- un circuit intégré prédiffusé programmable de type FPGA ;
- un circuit intégré à application spécifique de type ASIC.

Selon un autre aspect, la technique proposée se rapporte également à un produit programme d'ordinateur téléchargeable depuis un réseau de communication et/ou stocké sur un support lisible par ordinateur et/ou exécutable par un microprocesseur, comprenant des instructions de code de programme pour l'exécution d'un procédé de génération d'un temps de propagation de groupe négatif tel que décrit précédemment, lorsqu'il est exécuté sur un ordinateur.

La technique proposée vise également un support d'enregistrement lisible par un ordinateur sur lequel est enregistré un programme d'ordinateur comprenant des instructions de code de programme pour l'exécution des étapes du procédé tel que décrit précédemment, dans l'un quelconque de ses modes de réalisation.

Un tel support d'enregistrement peut être n'importe quelle entité ou dispositif capable de stocker le programme. Par exemple, le support peut comporter un moyen de stockage, tel qu'une ROM, par exemple un CD ROM ou une ROM de circuit microélectronique, ou encore un moyen d'enregistrement magnétique, par exemple une clé USB ou un disque dur.

D'autre part, un tel support d'enregistrement peut être un support transmissible tel qu'un signal électrique ou optique, qui peut être acheminé via un câble électrique ou optique, par radio ou par d'autres moyens, de sorte que le programme d'ordinateur qu'il contient est exécutable à distance. Le programme selon l'invention peut être en particulier téléchargé sur un réseau, par exemple le réseau Internet.

Les différents modes de réalisation mentionnés ci-dessus sont combinables entre eux pour la mise en œuvre de l'invention.

**Figures**

D'autres caractéristiques et avantages de l'invention apparaîtront plus clairement à la lecture de la description suivante d'un mode de réalisation préférentiel, donné à titre de simple exemple illustratif et non limitatif, et des dessins annexés, parmi lesquels :

[Fig 1] illustre, en relation avec l'art antérieur, dans un modèle simplifié, la propriété de génération d'un temps de propagation de groupe négatif ;

[Fig 2] présente les principales étapes d'un procédé de de génération d'un temps de propagation de groupe négatif, dans un mode de réalisation particulier de la technique proposée ;

[Fig 3] représente un synoptique classique d'une fonction numérique de type réponse impulsionnelle infinie d'ordre 1, dans un mode de réalisation particulier de la technique proposée ;

[Fig 4] illustre une réponse en temps de propagation de groupe idéale, pour la génération d'une fonction de type temps de propagation de groupe négatif et passe-bas, dans un mode de réalisation particulier de la technique proposée ;

[Fig 5] montre un exemple de signal de sortie présentant un temps de propagation de groupe négatif vis-à-vis d'un signal d'entrée, généré au moyen d'un procédé selon la technique proposée, dans un mode de réalisation particulier ;

[Fig 6] décrit une première implémentation d'un dispositif électronique de génération d'un temps de propagation de groupe négatif, dans un mode de réalisation particulier ;

[Fig 7] décrit une deuxième implémentation d'un dispositif électronique de génération d'un temps de propagation de groupe négatif, dans un mode de réalisation particulier ;

[Fig 8] décrit une troisième implémentation d'un dispositif électronique de génération d'un temps de propagation de groupe négatif, dans un mode de réalisation particulier ;

[Fig 9] décrit une quatrième implémentation d'un dispositif électronique de génération d'un temps de propagation de groupe négatif, dans un mode de réalisation particulier.

**EP 4 449 609 B1**

**Description détaillée de l'invention**

La présente technique se rapporte à un procédé de génération d'un temps de propagation de groupe négatif permettant de lever la plupart des freins et verrous cités en relation avec l'art antérieur, ouvrant ainsi le champ à de nombreuses applications pratiques dans de multiples domaines (industriel, médical, grand public, etc.). Plus particulièrement, la présente technique vise à proposer une solution de génération d'un temps de propagation de groupe négatif à la fois robuste et flexible, et donc industrialisable. Sur le plan de la robustesse, la solution proposée est fiable, en ce sens qu'elle ne présente pas le caractère aléatoire ou incertain des solutions existantes tel que décrit en relation avec l'art antérieur, eu égard à la valeur générée de temps de propagation de groupe négatif. Sur le plan de la flexibilité, la solution proposée permet de générer un temps de propagation de groupe négatif qui peut être supérieur à la seconde (voire de l'ordre de la minute, de l'heure, du jour, ou plus, sur certains signaux lents), sur une bande de fréquence plus importante que les solutions de l'art antérieur. La solution proposée est par ailleurs reconfigurable en ce sens qu'elle permet de modifier de manière dynamique et automatique la valeur de temps de propagation de groupe négatif (i.e. l'avance) générée par le dispositif électronique au sein duquel le procédé est mis en œuvre, et adaptative en ce sens qu'elle est capable de s'auto-configurer en fonction de la nature temporelle du signal d'entrée.

Ces objectifs sont atteints grâce à un procédé de génération d'un temps de propagation de groupe négatif qui repose sur un traitement numérique du signal d'entrée. Plus particulièrement, la technique proposée se rapporte à un procédé de génération d'un signal de sortie présentant un temps de propagation de groupe négatif vis-à-vis d'un signal d'entrée fourni en entrée d'un dispositif électronique, ce procédé se distinguant des solutions de l'art antérieur en ce que les étapes de génération du temps de propagation de groupe négatif sont mises en œuvre par une unité de traitement numérique programmable dudit dispositif électronique (l'unité de traitement numérique étant programmée à cette fin, par exemple au moyen d'un langage de programmation haut niveau). Comme détaillé par la suite, dans un mode de réalisation particulier de la technique proposée, l'unité de traitement numérique programmable est notamment configurée pour analyser les variations du signal d'entrée (e.g. valeurs minimales et maximales, temps de montée et/ou de descente, etc.), au fur et à mesure de l'acquisition des échantillons, et adapter de manière automatique en conséquence le temps de propagation de groupe négatif, autrement dit l'avance du signal de sortie.

On présente, en relation avec la **figure 2,** les principales étapes d'un tel procédé, dans un mode de réalisation particulier de la technique proposée. Selon une caractéristique particulière, de telles étapes font l'objet de multiples itérations.

Dans une étape 13, l'unité de traitement numérique obtient une fréquence d'échantillonnage associée à un signal numérique représentatif du signal d'entrée du dispositif électronique. Selon la nature de ce signal d'entrée, le signal numérique représentatif du signal d'entrée peut être :

-    ou bien le signal d'entrée lui-même, si celui-ci est déjà un signal numérique, auquel cas la fréquence d'échantillonnage correspond à une fréquence de sélection des valeurs du signal d'entrée, qui peut être contrôlée pour correspondre par exemple à la fréquence d'apparition des valeurs du signal d'entrée, à une fréquence moins élevée (consistant par exemple à sélectionner seulement un échantillon sur deux, ou sur trois, ou sur quatre, etc., des valeurs du signal d'entrée), ou à une fréquence plus élevée (auquel cas des valeurs initialement non présentes dans le signal numérique d'entrée sont par exemple extrapolées en fonction de valeurs précédentes du signal d'entrée) ;
-    ou bien le résultat d'une étape 12 de conversion analogique vers numérique du signal d'entrée, si celui-ci est un signal analogique, auquel cas la fréquence d'échantillonnage correspond à la fréquence à laquelle le signal analogique d'entrée est échantillonné, l'étape 12 de conversion analogique vers numérique étant éventuellement précédée d'une étape 11 de conditionnement du signal analogique d'entrée comprenant par exemple des opérations d'amplification et/ou de filtrage permettant de préparer le signal avant son traitement.

Quelle que soit la nature du signal d'entrée (numérique ou analogique), la fréquence d'échantillonnage associée au signal numérique représentatif du signal d'entrée peut donc être contrôlée par l'unité de traitement numérique programmable du dispositif électronique, selon des modalités détaillées ultérieurement en relation avec un mode de réalisation particulier de la technique proposée.

Dans une étape 14, l'unité de traitement numérique obtient une valeur de temps de propagation de groupe, dite valeur de temps de propagation de groupe négatif cible en ce sens qu'elle représente l'avance temporelle visée pour le signal de sortie, vis-à-vis du signal d'entrée. Une telle valeur est par exemple programmée manuellement par un utilisateur, au moins dans un premier temps, éventuellement sur la base d'une étude préliminaire par l'utilisateur des caractéristiques du signal d'entrée, et notamment de ses temps de variations. Une telle étude vise plus précisément à tenir compte de certaines contraintes à respecter afin d'assurer une génération optimale du temps de propagation de groupe négatif cible. En d'autres termes, il s'agit ici de prendre en compte le fait que l'avance réalisable (i.e. l'avance du signal de sortie qu'il est possible de synthétiser avec suffisamment de robustesse et de stabilité) dépend directement de la vitesse de variation du signal d'entrée. Ainsi, selon une caractéristique particulière, la valeur de temps de propagation de groupe négatif cible est inférieure ou égale au quart de la variation instantanée du signal d'entrée (i.e. d'un temps de montée courant ou d'un temps de descente courant du signal d'entrée, selon les cas) lorsque celui-ci est non déterministe, ou au quart de la période du signal d'entrée lorsque celui-ci est périodique. Des contrôles mis en œuvre par l'unité de traitement numérique peuvent éventuellement être implémentés, de manière à assurer que cette contrainte est respectée. Plus particulièrement, dans un mode de réalisation particulier, une analyse continue et automatique du signal d'entrée est mise en œuvre par l'unité de traitement numérique (par exemple à chaque acquisition d'une nouvelle valeur du signal numérique représentatif du signal d'entrée), permettant à cette unité de traitement d'estimer en temps-réel (ou quasi temps-réel) un temps de variation (e.g. de montée ou de descente) courant du signal d'entrée, et d'adapter en conséquence la valeur de temps de propagation de groupe négatif cible (autrement dit l'avance réalisable) en fonction de ce temps de variation courant. Selon une caractéristique particulière, la valeur de temps de propagation de groupe déterminée en étape 14 est ainsi fixée au quart du temps de variation courant ainsi estimé (ou à tout le moins à une valeur inférieure au quart du temps de variation courant).

Dans une étape 15, l'unité de traitement numérique détermine un ensemble de coefficients d'une équation aux différences, en fonction de la fréquence d'échantillonnage obtenue en étape 13 et de la valeur de temps de propagation de groupe négatif cible obtenue en étape 14.

L'équation aux différences a la forme générale suivante :

$$y[n] = \sum_{k=0}^{M} a_k x[n-k] + \sum_{k=1}^{N} b_k y[n-k]$$

L'équation aux différences permet notamment de calculer la valeur courante $y[n]$ du signal de sortie en fonction de la valeur courante du signal d'entrée $x[n]$ et, selon les cas, d'un certain nombre de valeurs précédentes du signal d'entrée et du signal de sortie, ces valeurs étant pondérées grâce aux coefficients déterminés en étape 15.

Selon une caractéristique particulière, la forme de l'équation aux différences (et plus particulièrement le nombre de coefficients calculés en étape 15) est déterminée en fonction d'un mode de fonctionnement sélectionné par l'utilisateur, parmi un mode récursif et un mode non récursif, et en fonction d'un ordre sélectionné pour ledit mode de fonctionnement. Le mode de fonctionnement peut par exemple correspondre à un mode de type réponse impulsionnelle infinie d'ordre 1 (IIR d'ordre 1), un mode de type réponse impulsionnelle infinie d'ordre 2 (IIR d'ordre 2), un mode de type réponse impulsionnelle finie d'ordre 1 (FIR d'ordre 1), un mode de type réponse impulsionnelle finie d'ordre 2 (FIR d'ordre 2), etc.

On décrit maintenant un exemple de détermination des coefficients de l'équation aux différences dans le cas d'un mode de fonctionnement de type réponse impulsionnelle infinie d'ordre 1 (IIR d'ordre 1) permettant de générer une fonction « *temps de propagation de groupe négatif - passe-bas* » (NGD PB). Dans un tel mode de fonctionnement, l'équation aux différences prend la forme suivante :

$$y[n] = a_0 x[n] + a_1 x[n-1] + a_1 b_1 y[n-1] \quad (1)$$

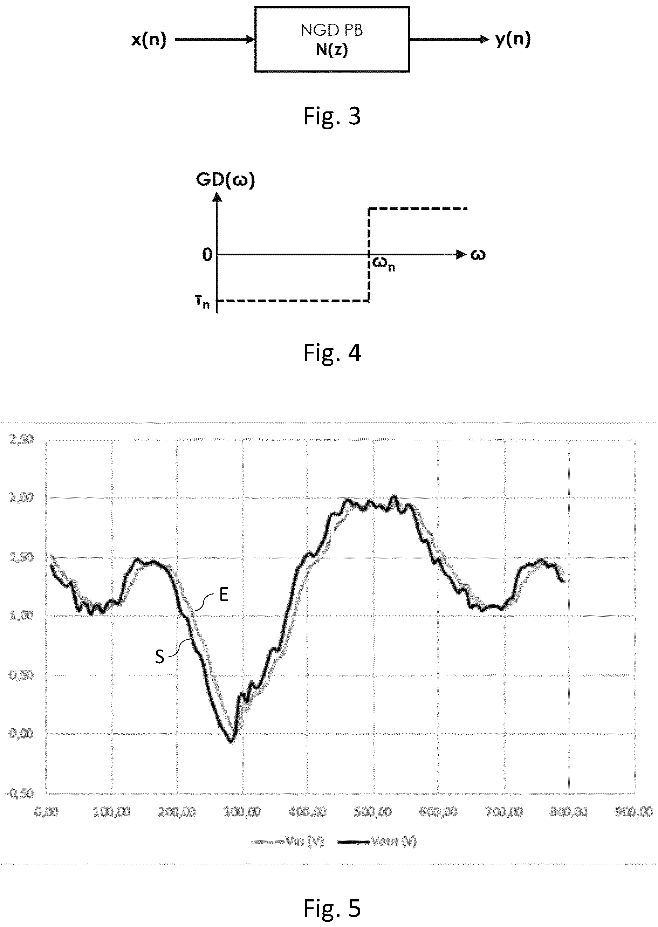

La **figure 3** représente le synoptique classique de la fonction numérique de type réponse impulsionnelle infinie d'ordre 1 :

$$N(z) = \frac{Y(z)}{X(z)} \quad (2)$$

où x(n) et y(n) sont respectivement les entrée et sortie discrètes, et n l'indice des échantillons (n=1,2,...).

Les coefficients $a_0$, $a_1$ et $b_1$ de l'équation aux différences (1) sont par exemple déterminés à partir de la forme canonique premier ordre analogique d'une fonction NGD PB, comme montré ci-après. Plus particulièrement, des études ont montré que la fonction de transfert (FT) analogique du premier ordre suivante est susceptible de se comporter comme une fonction NGD PB non familière :

$$N(s) = \frac{Y(s)}{X(s)} \quad (3)$$

ou

$$N(s) = \frac{1 + a\,s}{1 + b\,s} \quad (4)$$

avec s la variable de Laplace, et *a* et *b* des coefficients réels.

Les caractéristiques d'une fonction NGD PB peuvent par ailleurs être définies par la réponse en temps de propagation de groupe GD($\omega$) idéale telle qu'illustrée en relation avec la **figure 4.** Comme montré sur cette figure, les principaux paramètres de spécification sont la valeur de temps de propagation de groupe négatif cible $\tau_n$ et la pulsation en fonction de la fréquence de coupure $\omega_n = 2\pi f_n$.

Il a été montré dans la littérature que la génération d'une fonction NGB PB à partir de ces paramètres de spécification implique que les coefficients *a* et *b* de l'équation (4) prennent les valeurs suivantes :

$$a = \frac{\sqrt{\omega_n^2 \tau_n^2 + 4} - \omega_n \tau_n}{2\omega_n} \quad (5)$$

$$b = \frac{\sqrt{\omega_n^2 \tau_n^2 + 4} + \omega_n \tau_n}{2\omega_n} \quad (6)$$

Par ailleurs, pour pouvoir mettre en évidence la signature temporelle de la fonction NGD PB, le spectre de puissance du signal d'entrée X(j$\omega$) doit respecter la condition $\omega \leq \omega_{max} = \omega_n$.

La combinaison des équations (3) et (4) conduit à la nouvelle expression symbolique suivante en fonction des coefficients a et *b* :

$$Y(s) - X(s) = s\big[a\,X(s) - b\,Y(s)\big] \quad (7)$$

En adoptant l'hypothèse :

$$\begin{cases} x(0) = 0 \\ \dfrac{dx(t=0)}{dt} = 0 \\ y(0) = 0 \end{cases} \quad (8)$$

la transformée de Laplace inverse de la précédente équation symbolique s'écrit :

$$y(t) - x(t) = a\frac{dx(t)}{dt} - b\frac{dy(t)}{dt} \quad (9)$$

Cette équation est à l'origine des formules de calcul des coefficients $a_0$, $a_1$ et $b_1$ de l'équation (1). Pour ce faire, il est procédé à une discrétisation, en considérant un pas d'échantillonnage respectant la condition suivante afin de minimiser les incertitudes numériques :

$$\Delta t = T_e \leq \frac{|\tau_n|}{4} \quad (10)$$

Plus particulièrement, il est procédé à une discrétisation de la variable continue t en son échantillon :

$$t_n = n\,T_e \quad (11)$$

avec l'indice entier $n = 0,1,2,...,n_{max}$, où la valeur maximale $n_{max}$ est liée à la largeur de la fenêtre temporelle du signal d'entrée $t_{max}$ définie par :

$$n_{max} = Ent\left(\frac{t_{max}}{T_e}\right) \qquad (12)$$

avec *Ent(x)* la partie entière supérieure de x.

Par conséquent, on réalise mathématiquement la discrétisation par les substitutions suivantes :

$$\begin{cases} x(t) \rightarrow x(n) = x_n \\ y(t) \rightarrow y(n) = y_n \end{cases} \qquad (13)$$

Ceci implique les discrétisations des termes d'entrée et de sortie en dérivées suivantes :

$$\frac{dx(t)}{dt} \rightarrow \frac{\Delta x[nT_e]}{\Delta t} = \frac{x[n] - x[n-1]}{T_e} \qquad (14)$$

$$\frac{dy(t)}{dt} \rightarrow \frac{\Delta y[nT_e]}{\Delta t} = \frac{y[n] - y[n-1]}{T_e} \qquad (15)$$

En substituant les équations (13), (14) et (15) dans l'équation (9), on aboutit aux valeurs suivantes calculées en étape 15 pour les coefficients $a_0$, $a_1$ et $b_1$ de l'équation aux différences (1) :

$$a_0 = \frac{\omega_n(2T_e - \tau_n) + \sqrt{4 + \omega_n^2 \tau_n^2}}{\sqrt{4 + \omega_n^2 \tau_n^2} + \omega_n(\tau_n + 2T_e)}$$

$$a_1 = \frac{\omega_n \tau_n - \sqrt{4 + \omega_n^2 \tau_n^2}}{\sqrt{4 + \omega_n^2 \tau_n^2} + \omega_n(\tau_n + 2T_e)}$$

$$b_1 = \frac{\sqrt{4 + \omega_n^2 \tau_n^2} + \omega_n \tau_n}{\sqrt{4 + \omega_n^2 \tau_n^2} + \omega_n(\tau_n + 2T_e)}$$

où :

$\tau_n$ est une valeur négative correspondant au temps de propagation de groupe négatif cible, exprimée en seconde ;
$T_e$ correspond à la période d'échantillonnage (inverse de la fréquence d'échantillonnage obtenue en étape 13), exprimée en seconde ;
et

$$\omega_n = 2\pi/|\tau_n| \, .$$

De retour au cas général, dans une étape 16 itérative, l'équation aux différences dont les coefficients ont été déterminés en étape 15 est utilisée pour générer le signal de sortie présentant un temps de propagation de groupe (TPG) négatif vis-à-vis dudit signal d'entrée. Plus particulièrement, à chaque obtention (ou acquisition) d'une valeur courante du signal numérique représentatif du signal d'entrée - autrement dit à la fréquence d'échantillonnage - une valeur courante du signal de sortie est calculée au moyen de ladite équation aux différences.
Dans un mode de réalisation particulier, selon un principe déjà exposé précédemment, les dernières valeurs du signal d'entrée obtenues lors des dernières itérations de l'étape 16 sont analysées de manière à estimer un temps de montée courant ou un temps de descente courant du signal d'entrée (i.e. un temps de variation courant du signal d'entrée). Les résultats d'une telle estimation peuvent ainsi être exploités, dans une étape 17, pour adapter la valeur de temps de propagation de groupe négatif cible (en la positionnant par exemple de manière automatique au quart du temps de variation courant estimé), mais également pour adapter en conséquence la fréquence d'échantillonnage du signal d'entrée. Il s'agit ici par exemple de s'assurer de disposer dans la suite de la mise en œuvre du procédé de suffisamment d'échantillons pour pourvoir continuer à analyser de manière suffisamment fine les variations du signal d'entrée. Selon une caractéristique particulière, la fréquence d'échantillonnage (i.e. la fréquence d'échantillonnage utilisée pour la conversion du signal analogique en signal numérique lorsque le signal d'entrée du dispositif de temps de propagation de groupe négatif est un signal analogique, ou la fréquence de sélection des valeurs du signal d'entrée lorsque le signal d'entrée du dispositif de temps de propagation de groupe négatif est un signal numérique) est ainsi contrôlée et ajustée par l'unité de traitement numérique de manière à ce que la période d'échantillonnage soit de l'ordre du dixième du temps de variation courant estimé. Ainsi, le procédé de génération d'un temps de propagation de groupe négatif est adaptatif, c'est-à-dire qu'il est capable de s'auto-configurer en fonction de la nature temporelle du signal d'entrée.

La **figure 5** présente un exemple de signal de sortie S généré à partir d'un signal analogique d'entrée E (en l'espèce, l'évolution d'une tension exprimée en volt en fonction du temps exprimé en secondes), au moyen d'un procédé de génération d'un temps de propagation de groupe négatif selon la présente technique. Dans cet exemple, la période d'échantillonnage du signal analogique d'entrée est de six secondes, et la valeur de temps de propagation de groupe négatif cible est fixée à dix secondes. Comme cela peut être constaté sur cette figure, les variations d'amplitude du signal de sortie S correspondent bien à celles du signal d'entrée E, et le signal de sortie S présente bien l'avance escomptée d'une dizaine de secondes sur le signal d'entrée E.

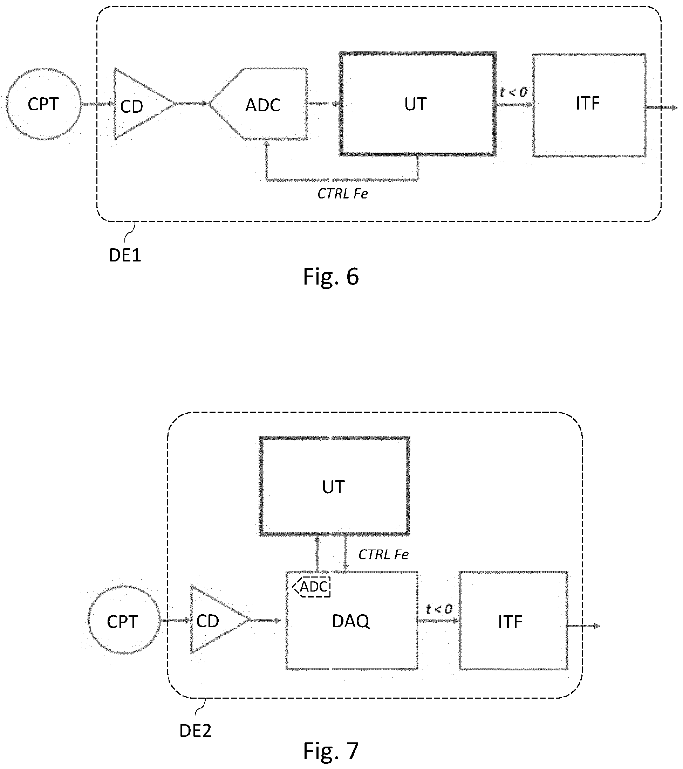

On présente maintenant, en relation avec les figures 6 à 9, divers modes d'implémentations possibles (DE1, DE2, DE3, DE4) d'un dispositif électronique de génération d'un temps de propagation de groupe négatif, selon différents modes de réalisation particuliers de la technique proposée. Sur toutes ces figures, les éléments de même nature sont identifiés par une même référence. Dans tous les modes de réalisation particuliers présentés, le signal d'entrée à traiter est un signal analogique délivré par un capteur CPT, et le dispositif électronique (DE1, DE2, DE3, DE4) de génération d'un temps de propagation de groupe négatif comprend un bloc CD de conditionnement du signal analogique d'entrée, un bloc ADC de conversion analogique vers numérique du signal analogique conditionné, une unité de traitement numérique programmable UT permettant de traiter le signal numérique délivré par le convertisseur analogique vers numérique DAC afin de générer un signal de sortie numérique présentant un temps de propagation de groupe négatif vis-à-vis de ce signal, et une interface ITF de sortie permettant par exemple d'interfacer le dispositif électronique avec des dispositifs externes en charge d'exploiter le signal de sortie délivré par l'unité de traitement numérique UT, éventuellement après une conversion numérique vers analogique de ce signal.

Selon la technique proposée, l'unité de traitement numérique programmable UT comprend notamment, dans un mode de réalisation particulier :

- des moyens d'obtention d'une fréquence d'échantillonnage associée au signal numérique représentatif du signal d'entrée, cette fréquence correspondant, dans les modes de réalisation particuliers illustrés sur les figures 6 à 9, à la fréquence d'échantillonnage du signal analogique délivré par le capteur CPT, après conditionnement ;
- des moyens d'obtention d'une valeur de temps de propagation de groupe, dite valeur de temps de propagation de groupe négatif cible ;
- des moyens de détermination d'un ensemble de coefficients d'une équation aux différences, en fonction de ladite fréquence d'échantillonnage et de de ladite valeur de temps de propagation de groupe négatif cible ;
- des moyens de calcul, à l'acquisition d'une valeur courante du signal numérique, d'une valeur courante correspondante dudit signal de sortie, au moyen de ladite équation aux différences.

L'unité de traitement numérique programmable comprend également, dans un mode de réalisation particulier, des moyens de contrôle (CTRL Fe) de la fréquence d'échantillonnage, lui permettant d'adapter automatiquement la fréquence d'échantillonnage utilisée au niveau du bloc ADC de conversion analogique vers numérique en fonction de l'évolution temporelle du signal numérique délivré par ce bloc (et notamment d'une analyse des temps de montée et/ou de descente de ce signal).

Ces éléments en commun (blocs et moyens) d'un dispositif électronique de génération d'un temps de propagation de groupe négatif, présentés précédemment, sont cependant susceptibles d'être implémentés de différentes manières, comme montré en relation avec les figures 6 à 9, le choix entre ces différents modes d'implémentation pouvant notamment être effectué en fonction de différentes contraintes opérationnelles (par exemple des contraintes d'intégration, de vitesse de traitement, de coût, etc.).

Dans un premier mode d'implémentation, illustré en relation avec la **figure 6,** l'unité de traitement numérique programmable UT prend la forme d'un microcontrôleur non spécialisé classique (par exemple un microcontrôleur embarqué sur une carte de type carte Arduino), les blocs de conditionnement CD et de conversion analogique vers numérique ADC du signal étant disposés en amont de ce microcontrôleur. Un tel mode d'implémentation offre une solution moins intégrée et présentant une plus faible cadence de traitement que d'autres décrites ultérieurement, mais elle est également moins coûteuse et s'avère adaptée lorsqu'il s'agit de traiter des signaux particulièrement lents, en ce qu'elle permet de générer un temps de propagation de groupe négatif de l'ordre de la seconde, de la minute, de l'heure, voire de plusieurs jours.

Dans un deuxième mode d'implémentation, illustré en relation avec la **figure 7,** l'unité de traitement numérique programmable UT prend la forme d'un ordinateur, le traitement numérique du signal étant mis en œuvre par un programme exécuté sur cet ordinateur, éventuellement au sein d'une machine virtuelle. Dans ce cas un module matériel d'acquisition de données (« Data Acquisition » ou DAQ en anglais), par exemple une carte d'acquisition de donnée, fait office d'interface entre le capteur CPT et l'ordinateur. Plus particulièrement, ce module matériel d'acquisition de données DAQ est contrôlé par l'ordinateur, et il intègre le bloc de conversion analogique vers numérique ADC. Ce mode d'implémentation est intéressant en ce qu'il offre par exemple la possibilité à un utilisateur de pouvoir modifier en temps réel les paramètres du programme de traitement numérique du signal. Il accorde également plus de flexibilité dans le choix du langage de programmation, et permet notamment par exemple d'utiliser un langage de programmation graphique tel que LabView, très prisé dans le monde industriel et en particulier dans le domaine des systèmes de contrôle/commande.

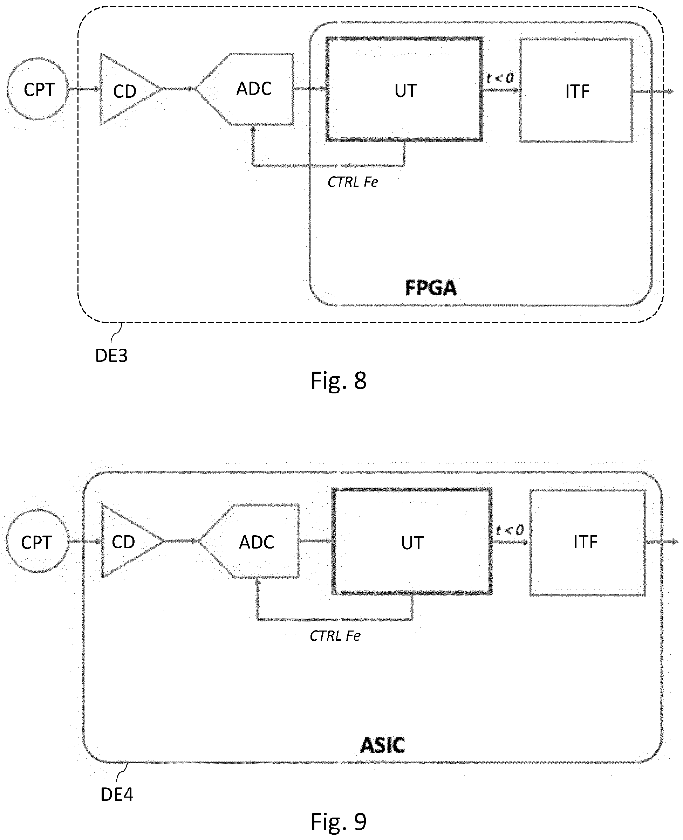

Dans un troisième mode d'implémentation, illustré en relation avec la **figure 8,** le traitement numérique du signal est mis en œuvre au sein d'un circuit intégré prédiffusé programmable de type FPGA (« Field-Programmable Gate Array » en anglais) dans lequel est embarqué le cœur d'un processeur (e.g. ARM, RISC-V, etc.) décrit dans un langage de description matériel de type Verilog ou VHDL (processeur de type « soft-core »), ce cœur de processeur formant l'unité de traitement numérique UT. Les interfaces ITF (par exemple de type SPI de l'anglais « Serial Peripheral Interface », USB de l'anglais « Universal Serial Bus », ou encore I2C de l'anglais « Inter-Integrated Circuit ») permettant la communication avec des dispositifs ou périphériques électroniques extérieurs sont également éventuellement déjà intégrées dans le composant reconfigurable FPGA. Un tel mode d'implémentation est avantageux en termes d'intégration, et permet d'obtenir des cadences de traitement élevées. Dans une telle implémentation, le bloc de conversion analogique vers numérique ADC positionné en amont du composant reconfigurable FPGA est typiquement un convertisseur analogique vers numérique haute vitesse.

Dans un quatrième mode d'implémentation, illustré en relation avec la **figure 9,** le traitement numérique du signal est mis en œuvre au sein d'un circuit intégré à application spécifique de type ASIC (« Application-Specific Integrated Circuit » en anglais) dans lequel est embarqué le cœur d'un processeur (e.g. ARM, RISC-V, etc.) implémenté en technologie CMOS ou autres (processeur de type « hard-core »), ce cœur de processeur formant l'unité de traitement numérique UT. Un ASIC permet notamment d'intégrer toute la chaine de traitement, i.e. le bloc de conditionnement CD, le bloc de conversion analogique vers numérique ADC sous la forme d'un convertisseur analogique vers numérique haute vitesse, ainsi que les interfaces ITF (e.g. SPI, I2C, USB, etc.) permettant la communication avec des dispositifs ou périphériques électroniques extérieurs. Un tel mode d'implémentation est avantageux en termes d'intégration, et est également celui qui, de tous les modes d'implémentations présentés en relation avec les figures 6 à 9, permet d'obtenir les cadences de traitement les plus élevées. Il est ainsi adapté non seulement pour le traitement de signaux d'évolution lentes (en permettant la génération de temps de propagation de groupe négatifs allant au-delà de la seconde, de la minute, de l'heure, voire de plusieurs jours), mais également pour le traitement de signaux d'évolution relativement rapides, en permettant par exemple de générer un temps de propagation de groupe négatif de l'ordre de la microseconde ou de la milliseconde.

Bien entendu, ces modes d'implémentations sont donnés à titre purement illustratif et non limitatif, et d'autres modes d'implémentation peuvent être envisagés dans le cadre de la présente technique, par exemple une intégration du procédé de génération d'un temps de propagation de groupe négatif sur des processeurs génériques grand-public ou au contraire spécialisés à certains domaines d'activité (industrie 4.0, conduite autonome, solutions de mobilité intelligente, système aéronautiques, etc.), voire sur des composants de type mémoire Flash/EEPROM très répandus (notamment dans les smartphones).

La présente technique de génération d'un temps de propagation de groupe négatif à base de circuits numériques, dans l'un quelconque des modes de réalisation décrits précédemment, permet donc de lever la majorité des freins et verrous technologiques associés aux solutions de l'art antérieur, basées sur des circuits analogiques. Elle constitue ainsi une alternative robuste et flexible ouvrant le champ à un grand nombre d'applications dans des domaines aussi variés que les applications industrielles (par exemple pour la réduction ou la suppression des latences des signaux de détection issus de capteurs, observées dans les systèmes de contrôle/commande industriels, notamment dans les domaines de la robotique, de l'automatique, des bâtiments intelligents ou « smart-building », etc.), les réseaux d'énergie intelligents ou « smart-grid » (par exemple pour mettre en œuvre une gestion efficace de la production d'énergie électrique, en anticipant des variations de conditions météorologiques), le traitement du signal dans les systèmes embarqués critiques (par exemple pour diminuer les temps de réactions de ces systèmes critiques, anticiper des évènements issus de capteurs, prédire des défaillance et des pannes, notamment dans le domaine des véhicules autonomes, de l'aéronautique, du nucléaire, etc.), la reconstruction de signal en ingénierie médicale (par exemple pour reconstituer un signal noyé sous le bruit comme peut l'être un électroencéphalogramme, ou fortement dégradé par des interférences comme peut l'être un électrocardiogramme), l'intelligence artificielle (par exemple pour effectuer de la prédiction en temps réel d'information), etc.

**Revendications**

1. Procédé de génération, par un dispositif électronique, à partir d'un signal fourni en entrée dudit dispositif électronique, d'un signal de sortie présentant un temps de propagation de groupe négatif vis-à-vis dudit signal d'entrée, ledit procédé comprenant au moins une itération des étapes suivantes, mises en œuvre par une unité de traitement numérique programmable dudit dispositif électronique :

   - l'obtention (13) d'une fréquence d'échantillonnage associée à un signal numérique représentatif dudit signal d'entrée ;
   - l'obtention (14) d'une valeur de temps de propagation de groupe, dite valeur de temps de propagation de groupe négatif cible ;
   - la détermination (15) d'un ensemble de coefficients d'une équation aux différences, en fonction de ladite fréquence d'échantillonnage et de ladite valeur de temps de propagation de groupe négatif cible, ladite équation aux différences définissant une relation entre une valeur dudit signal de sortie, une valeur dudit signal d'entrée et au moins une valeur précédente dudit signal d'entrée et/ou dudit signal de sortie ;
   - le calcul (16), à l'acquisition d'une valeur courante dudit signal numérique, d'une valeur courante correspondante dudit signal de sortie, au moyen de ladite équation aux différences ;

   ledit procédé étant **caractérisé en ce que** ladite valeur de temps de propagation de groupe négatif cible est contrôlée par ladite unité de traitement numérique programmable pour être inférieure ou égale au quart d'un temps de variation courant en montée ou en descente dudit signal d'entrée lorsque ledit signal d'entrée est non déterministe, ou au quart d'une période dudit signal d'entrée lorsque ledit signal d'entrée est périodique.

2. Procédé selon la revendication 1, **caractérisé en ce que** ladite équation aux différences est déterminée en fonction d'un mode de fonctionnement sélectionné parmi un mode récursif et un mode non récursif, et en fonction d'un ordre associé audit mode de fonctionnement.

3. Procédé selon la revendication 1, **caractérisé en ce que** ledit signal d'entrée est un signal analogique, et **en ce que** le procédé comprend une étape de conversion analogique vers numérique (12) dudit signal d'entrée, ladite étape de conversion comprenant l'échantillonnage dudit signal d'entrée à ladite fréquence d'échantillonnage, délivrant ledit signal numérique représentatif dudit signal d'entrée.

4. Procédé selon la revendication 3, **caractérisé en ce qu'**il comprend, préalablement à ladite étape de conversion analogique vers numérique (12), une étape de conditionnement (11) dudit signal analogique d'entrée.

5. Procédé selon la revendication 1, **caractérisé en ce que** ladite fréquence d'échantillonnage du signal d'entrée est contrôlée par ladite unité de traitement numérique programmable.

6. Procédé selon la revendication 5, **caractérisé en ce que** ladite fréquence d'échantillonnage du signal d'entrée est adaptée en fonction d'un temps de montée et/ou de descente courant dudit signal d'entrée.

7. Dispositif électronique de génération d'un signal de sortie présentant un temps de propagation de groupe négatif vis-à-vis d'un signal fourni en entrée dudit dispositif électronique, ledit dispositif électronique comprenant une unité de traitement numérique programmable comprenant :

   - des moyens d'obtention d'une fréquence d'échantillonnage associée à un signal numérique représentatif dudit signal d'entrée ;
   - des moyens d'obtention d'une valeur de temps de propagation de groupe, dite valeur de temps de propagation de groupe négatif cible ;
   - des moyens de détermination d'un ensemble de coefficients d'une équation aux différences, en fonction de ladite fréquence d'échantillonnage et de de ladite valeur de temps de propagation de groupe négatif cible, ladite équation aux différences définissant une relation entre une valeur dudit signal de sortie, une valeur dudit signal d'entrée et au moins une valeur précédente dudit signal d'entrée et/ou dudit signal de sortie ;
   - des moyens de calcul, à l'acquisition d'une valeur courante dudit signal numérique, d'une valeur courante correspondante dudit signal de sortie, au moyen de ladite équation aux différences ;

   ledit dispositif électronique étant **caractérisé en ce que** ladite valeur de temps de propagation de groupe négatif cible est contrôlée par ladite unité de traitement numérique programmable pour être inférieure ou égale au quart d'un temps de variation courant en montée ou en descente dudit signal d'entrée lorsque ledit signal d'entrée est non déterministe, ou au quart d'une période dudit signal d'entrée lorsque ledit signal d'entrée est périodique.

8. Dispositif électronique selon la revendication 7, **caractérisé en ce qu'**il comprend un convertisseur analogique vers numérique comprenant des moyens d'échantillonnage dudit signal d'entrée à ladite fréquence d'échantillonnage, délivrant ledit signal numérique représentatif dudit signal d'entrée, lorsque ledit signal d'entrée est analogique.

9. Dispositif électronique selon la revendication 7, **caractérisé en ce que** ladite unité de traitement numérique programmable appartient au groupe comprenant :

- un microcontrôleur ;
- une machine virtuelle exécutée sur un ordinateur ;
- un circuit intégré prédiffusé programmable de type FPGA ;
- un circuit intégré à application spécifique de type ASIC.

10. Produit programme d'ordinateur téléchargeable depuis un réseau de communication et/ou stocké sur un support lisible par ordinateur et/ou exécutable par un microprocesseur, **caractérisé en ce qu'**il comprend des instructions de code de programme pour l'exécution d'un procédé selon l'une quelconque des revendications 1 à 6, lorsqu'il est exécuté par un ordinateur.

**Patentansprüche**

1. Verfahren zur Erzeugung eines Ausgangssignals, das dazu dient, mithilfe einer elektronischen Vorrichtung ausgehend von einem durch die elektronische Vorrichtung bereitgestellten Eingangssignal ein Ausgangssignal mit gegenüber dem Eingangssignal negativer Gruppenlaufzeit zu erzeugen, wobei das Verfahren zumindest eine Iteration der folgenden Schritte umfasst, die von einer programmierbaren digitalen Verarbeitungseinheit der elektronischen Vorrichtung ausgeführt werden und die darin bestehen, dass:

- eine Abtastfrequenz für ein Digitalsignal, welches das Eingangssignal darstellt, gewonnen wird (13);
- ein Gruppenlaufzeitwert, auch als negativer Ziel-Gruppenlaufzeitwert bezeichnet, ermittelt wird (14);
- ein Satz von Koeffizienten einer Differenzengleichung in Abhängigkeit zu der Abtastfrequenz und dem negativen Ziel-Gruppenlaufzeitwert bestimmt wird (15), wobei die Differenzengleichung eine Relation zwischen einem Wert des Ausgangssignals, einem Wert des Eingangssignals und zumindest einem dem Wert des Eingangssignals und/oder des Ausgangssignals vorangehenden Wert definiert;
- bei der Erfassung eines aktuellen Werts des Digitalsignals ein entsprechender aktueller Wert des Ausgangssignals mithilfe der Differenzengleichung berechnet wird (16);

wobei das Verfahren **dadurch gekennzeichnet ist, dass** der negative Ziel-Gruppenlaufzeitwert von der programmierbaren digitalen Verarbeitungseinheit derart geregelt wird, dass er kleiner oder gleich einem Viertel einer aktuellen Anstiegs- oder Abfallzeit des Eingangssignals ist, wenn es sich bei dem Eingangssignal um kein deterministisches Signal handelt, oder dass er kleiner oder gleich einem Viertel einer Periode des Eingangssignals ist, wenn es sich bei dem Eingangssignal um ein periodisches Signal handelt.

2. Verfahren nach Anspruch 1, **dadurch gekennzeichnet, dass** die Differenzengleichung in Abhängigkeit zu einem ausgewählten Betriebsmodus, bei dem es sich entweder um einen rekursiven oder um einen nicht-rekursiven Modus handelt, und in Abhängigkeit zu einer dem entsprechenden Betriebsmodus zugeordneten Vorschrift bestimmt wird.

3. Verfahren nach Anspruch 1, **dadurch gekennzeichnet, dass** es sich bei dem Eingangssignal um ein Analogsignal handelt, und dass das Verfahren einen Analog-Digital-Umsetzungsschritt (12) zur Umsetzung des analogen Eingangssignals in ein Digitalsignal umfasst, wobei der Umsetzungsschritt das Abtasten des Eingangssignals mit besagter Abtastfrequenz und das Bereitstellen des das Eingangssignal darstellenden Digitalsignals umfasst,

4. Verfahren nach Anspruch 3, **dadurch gekennzeichnet, dass** das Verfahren vor dem Analog-Digital-Umsetzungsschritt (12) einen Signalkonditionierungsschritt (11) zur Konditionierung des analogen Eingangssignals umfasst.

5. Verfahren nach Anspruch 1, **dadurch gekennzeichnet, dass** die Abtastfrequenz des Eingangssignals von der programmierbaren digitalen Verarbeitungseinheit geregelt wird.

6. Verfahren nach Anspruch 5, **dadurch gekennzeichnet, dass** die Abtastfrequenz des Eingangssignals in Abhängigkeit zu einer aktuellen Anstiegs- und/oder Abfallzeit des Eingangssignals angepasst wird.

7. Elektronische Vorrichtung zur Erzeugung eines Ausgangssignals mit negativer Gruppenlaufzeit gegenüber einem am Eingang der elektronischen Vorrichtung bereitgestellten Signal, wobei die elektronische Vorrichtung eine programmierbare digitale Verarbeitungseinheit umfasst, welche Folgendes umfasst:

- Mittel zur Gewinnung einer Abtastfrequenz für ein Digitalsignal, welches das Eingangssignal darstellt;
- Mittel zur Gewinnung eines Gruppenlaufzeitwerts, der auch als negativer Ziel-Gruppenlaufzeitwert bezeichnet wird;
- Mittel zur Bestimmung eines Satzes von Koeffizienten einer Differenzengleichung in Abhängigkeit zu der Abtastfrequenz und dem negativen Ziel-Gruppenlaufzeitwert, wobei die Differenzengleichung eine Relation zwischen einem Wert des Ausgangssignals, einem Wert des Eingangssignals und zumindest einem dem Wert des Eingangssignals und/oder des Ausgangssignals vorangehenden Wert definiert;
- Berechnungsmittel, die bei der Erfassung eines aktuellen Werts des Digitalsignals mithilfe der Differenzengleichung einen entsprechenden aktuellen Wert des Ausgangssignals berechnen;

wobei die elektronische Vorrichtung **dadurch gekennzeichnet ist, dass** der negative Ziel-Gruppenlaufzeitwert von der programmierbaren digitalen Verarbeitungseinheit derart geregelt wird, dass er kleiner oder gleich einem Viertel einer aktuellen Anstiegs- oder Abfallzeit des Eingangssignals ist, wenn es sich bei dem Eingangssignal um kein deterministisches Signal handelt, oder kleiner oder gleich einem Viertel einer Periode des Eingangssignals ist, wenn es sich bei dem Eingangssignal um ein periodisches Signal handelt.

8. Elektronische Vorrichtung nach Anspruch 7, **dadurch gekennzeichnet, dass** sie einen Analog-Digital-Umsetzer umfasst, welcher Abtastmittel zum Abtasten des Eingangssignals mit besagter Abtastfrequenz aufweist, wodurch das Digitalsignal, welches das Eingangssignal darstellt, bereitgestellt wird, wenn es sich bei dem Eingangssignal um ein Analogsignal handelt.

9. Elektronische Vorrichtung nach Anspruch 7, **dadurch gekennzeichnet, dass** die programmierbare digitale Verarbeitungseinheit zu der Gruppe gehört, welche umfasst:

- einen Mikrocontroller;
- eine virtuelle Maschine, die auf einem Computer ausgeführt wird;
- einen feldprogrammierbaren integrierten FPGA-Schaltkreis;
- einen anwendungsspezifischen integrierten ASIC-Schaltkreis.

10. Computerprogrammprodukt, das über ein Kommunikationsnetzwerk herunterladbar ist und/oder auf einem computerlesbaren Medium gespeichert ist und/oder von einem Mikroprozessor ausgeführt werden kann, **dadurch gekennzeichnet, dass** das Produkt Programmcode-Anweisungen zum Ausführen eines Verfahrens nach einem der Ansprüche 1 bis 6 umfasst, wenn das Produkt von einem Computer ausgeführt wird.

**Claims**

1. Method for generating, by an electronic device, from a signal supplied as input to said electronic device, an output signal having a negative group delay with respect to said input signal, comprising at least one iteration of the following steps, implemented by a programmable digital processing unit of said electronic device:

- obtaining (13) a sampling frequency associated with a digital signal representative of said input signal;
- obtaining (14) a group delay value, referred to as a target negative group delay value;
- determining (15) a set of coefficients from a difference equation, as a function of said sampling frequency and said target negative group delay value, said difference equation defining a relationship between a value of said output signal, a value of said input signal and at least one previous value of said input signal and/or said output signal;
- calculating (16), on acquisition of a current value of said digital signal, a corresponding current value of said output signal, by means of said difference equation, said method being **characterized in that** said target negative group delay value being controlled by said programmable digital processing unit to be less than or equal to a quarter of a current rise or fall variation time of said input signal when said input signal is non-deterministic, or to a quarter of a period of said input signal when said input signal is periodic.

2. Method according to claim 1, **characterised in that** said difference equation is determined as a function of an operating mode selected from a recursive mode and a non-recursive mode, and as a function of an order associated with said operating mode.

3. Method according to claim 1, **characterised in that** said input signal is an analogue signal, and **in that** the method comprises an analogue-to-digital conversion step (12) of said input signal, said conversion step comprising sampling said input signal at said sampling frequency, providing said digital signal representative of said input signal.

4. Method according to claim 3, **characterised in that** it comprises, prior to said analogue-to-digital conversion step (12), a step of conditioning (11) said analogue input signal.

5. Method according to claim 1, **characterised in that** said sampling frequency of the input analogue signal is controlled by said programmable digital processing unit.

6. Method according to claim 5, **characterised in that** said sampling frequency of the input analogue signal is adapted as a function of a current rise and/or fall time of said input signal.

7. Electronic device for generating an output signal having a negative group delay with respect to a signal supplied as input to said electronic device, said electronic device comprising a programmable digital processing unit comprising:

- means for obtaining a sampling frequency associated with a digital signal representative of said input signal;
- means for obtaining a group propagation time value, referred to as target negative group propagation time value;
- means for determining a set of coefficients of a difference equation as a function of said sampling frequency and said target negative group propagation time value, said difference equation defining a relationship between a value of said output signal, a value of said input signal and at least one previous value of said input signal and/or said output signal;
- means for calculating, on acquisition of a current value of said digital signal, a corresponding current value of said output signal, by means of said difference equation; said electronic device being **characterized in that** said target negative group propagation time value being controlled by said programmable digital processing unit so as to be less than or equal to a quarter of a time of current variation in rise or fall of said input signal when said input signal is non-deterministic, or to a quarter of a period of said input signal when said input signal is periodic.

8. Electronic device according to claim 7, **characterised in that** it comprises an analogue-to-digital converter comprising means for sampling said input signal at said sampling frequency, delivering said digital signal representative of said input signal, when said input signal is analogue.

9. Electronic device according to claim 7, **characterised in that** said programmable digital processing unit belongs to the group comprising:

- a microcontroller;
- a virtual machine running on a computer;
- an FPGA-type programmable prediffused integrated circuit;
- and an ASIC-type integrated circuit with a specific application.

10. Computer program which can be downloaded from a communications network and/or stored on a computer-readable medium and/or executable by a microprocessor, **characterised in that** it comprises program code instructions for executing a method according to any one of claims 1 to 6, when executed on a computer.

Fig. 1

Fig. 2

Fig. 3

Fig. 4

Fig. 5

Fig. 6

Fig. 7

Fig. 8

Fig. 9

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **RAVELO BLAISE et al.** *Low-Pass NGD Numerical Function and STM32 MCU Emulation Test*, 10 September 2021
- **RAVELO BLAISE**. *Elementary NGD IIR/FIR Systems"*, 01 December 2014
- **HENNING U VOSS**. *A universal negative group delay filter for the prediction of band-limited signais*, 22 June 2017